# EUROPEAN PATENT APPLICATION

(11) **EP 4 579 936 A1**
(43) Date of publication of application: **02.07.2025**
(21) Application number: 23867211.7
(22) Date of filing: 23.08.2023
(51) Int. Cl.: H01M 50/569, H01M 50/503, G01R 31/385

(54) **BATTERY CELL GROUP AND VOLTAGE ACQUISITION METHOD**

(30) Priority: 23.09.2022 CN 202211165532
(71) Applicant: Sunwoda Huizhou New Power Co., Ltd., Huizhou, Guangdong 516100 (CN)
(72) Inventor: LEI, Jingjing, Huizhou, Guangdong 516100 (CN); LIAO, Zhiyong, Huizhou, Guangdong 516100 (CN); CHEN, Binbin, Huizhou, Guangdong 516100 (CN)
(74) Representative: Ostriga Wirths und Vorwerk Patentanwälte PartGmbB
(86) International application number: PCT/CN2023/114459
(87) International publication number: WO 2024/060918

(57) **Abstract**

A battery module and a voltage acquisition method are disclosed. The battery module includes: a plurality of cells; two groups of connecting plates arranged in parallel, with all the connecting plates of each group distributed in an arrangement direction of the cells; a first acquisition cable including a plurality of first conductors arranged in parallel, and a second acquisition cable stacked with the first acquisition cable and including a plurality of second conductors. In a direction from a head end to a tail end of a first group of connecting plates, and then from a tail end to a head end of a second group of connecting plates, at least some of the first conductors are connected to some of the connecting plates in an arrangement order, at least some of the second conductors are connected to other connecting plates in an arrangement order, and at least one second conductor is arranged between at least one group of adjacent first conductors. The battery module allows to reduce the maximum voltage difference between corresponding conductors of the first acquisition cable and the second acquisition cable, reducing the risk of electric leakage.

## Description

### CROSS-REFERENCE TO RELATED APPLICATION

This application is filed on the basis of Chinese patent application No. 202211165532.1 filed on September 23, 2022, and claims priority of the Chinese patent application, the entire contents of which are incorporated herein by reference.

### TECHNICAL FIELD

The present disclosure relates to the technical field of energy storage devices, and in particular to a battery module and a voltage acquisition method.

### BACKGROUND

As an energy supply device for an electric vehicle, battery module is one of the important components of the electric vehicle. In addition to including a plurality of cells, the battery module further includes flexible flat cables (FFCs) for voltage signals acquisition. In the related art, the battery module is typically provided with two FFCs, each of the FFCs includes a plurality of conductors arranged in parallel, and all the conductors of each of the FFCs are connected to corresponding cells respectively. However, such mode may lead to an excessively high voltage difference between the corresponding conductors of the two FFCs. When there are foreign objects between the two FFCs, the excessively high voltage difference can easily cause faults such as electric leakage.

### SUMMARY

The present disclosure aims at solving at least one of the technical problems existing in the related art. To this end, the present disclosure proposes a battery module that can reduce the maximum voltage difference between conductors and reduce the risk of electric leakage.

The present disclosure further proposes a voltage acquisition method.

The battery module according to a first embodiment of the present disclosure includes:
a plurality of cells;
two groups of connecting plates, where the two groups of connecting plates are arranged in parallel, and all the connecting plates of each group distributed in an arrangement direction of the cells;
a first acquisition cable, which includes a plurality of first conductors arranged in parallel, and
a second acquisition cable, which is stacked with the first acquisition cable and includes a plurality of second conductors, where in a direction from a head end to a tail end of a first group of connecting plates, and then from a tail end to a head end of a second group of connecting plates, at least some of the first conductors are connected to some of the connecting plates in an arrangement order of the first conductors, at least some of the second conductors are connected to other connecting plates in an arrangement order of the second conductors, and at least one of the second conductors is arranged between at least one group of adjacent first conductors.

The battery module according to the embodiment of the present disclosure at least has the following beneficial effects.

By arranging at least one second conductor between at least one group of adjacent first conductors, jump voltage acquisition by the first acquisition cable and the second acquisition cable can be achieved, thereby reducing the maximum voltage difference between corresponding conductors of the first acquisition cable and the second acquisition cable and reducing the risk of electric leakage.

In other embodiments of the present disclosure, in the direction from the head end to the tail end of the first group of connecting plates, and then from the tail end to the head end of the second group of connecting plates, the first conductors and the second conductors are connected to the respective connecting plates in an alternating and sequential manner.

In other embodiments of the present disclosure, at least one of the second conductors is arranged between each of the plurality of groups of adjacent first conductors, and/or a plurality of the second conductors are arranged between at least one group of adjacent first conductors.

In other embodiments of the present disclosure, the first acquisition cable is provided with a vacant position corresponding to at least one of the second conductors, and/or the second acquisition cable is provided with a vacant position corresponding to at least one of the first conductors.

In other embodiments of the present disclosure, one of the plurality of connecting plates is used as an input terminal of the battery module, and a plurality of adjacent conductors of the same acquisition cable are connected to the input terminal.

In other embodiments of the present disclosure, the input terminal is connected to a first one of the cells, the input terminal is connected with a first one of the first conductors and a second one of the first conductors, and at least one of the second conductors is arranged between each of a plurality of groups of adjacent first conductors after the first one of the first conductors.

In other embodiments of the present disclosure, the second acquisition cable is provided with a vacant position corresponding to the second one of the first conductors.

In other embodiments of the present disclosure, in the direction from the head end to the tail end of the first group of connecting plates, and then from the tail end to the head end of the second group of connecting plates, a last one of the first conductors and a last one of the second conductors are connected to the two adjacent connecting plates in sequence.

The voltage acquisition method according to a second embodiment of the present disclosure includes:
preparing a plurality of cells, a plurality of connecting plates, a first acquisition cable, and a second acquisition cable, where the plurality of cells are arranged in sequence, the plurality of connecting plates are divided into two groups, all the connecting plates of each group are distributed in an arrangement direction of the cells, the first acquisition cable includes a plurality of first conductors arranged in parallel, and the second acquisition cable includes a plurality of second conductors arranged in parallel; and
stacking the first acquisition cable with the second acquisition cable, in a direction from the head end to the tail end of a first group of connecting plates, and then from the tail end to the head end of a second group of connecting plates, connecting at least some of the first conductors to some of the connecting plates in an arrangement order of the first conductors, connecting at least some of the second conductors to other connecting plates in an arrangement order of the second conductors, and arranging at least one of the second conductors between at least one group of adjacent first conductors, so that a voltage difference between each of the first conductors and a corresponding second conductor is lower than a set value.

In other embodiments of the present disclosure, a sum of the number of the first conductors and the number of the second conductors is greater than the number of connection points, and the method further includes: judging whether the voltage difference is greater than the set value after a group of the first conductors and the second conductors are all connected to the respective connecting plates, and in response to the voltage difference being greater than the set value, forming a vacant position corresponding to at least one of the first conductors and the second conductors.

Additional aspects and advantages of the present disclosure will be set forth in part in the description which follows, and in part will be obvious from the description, or may be learned by the practice of the present disclosure.

### BRIEF DESCRIPTION OF DRAWINGS

The present disclosure will be further described below in conjunction with the accompanying drawings and embodiments, where:
FIG.1 is a top view of a battery module in a first embodiment of the present disclosure;
FIG.2 is a schematic view of FIG.1 in which cells and a module housing are hidden;
FIG.3 is a schematic view of the connection between a first acquisition cable and connecting plates in FIG. 1;
FIG.4 is a schematic view of the connection between the second acquisition cable and the connecting plates in FIG. 1;
FIG.5 is a side view of the connection of the first acquisition cable and the second acquisition cable with a connector in FIG.1;
FIG.6 is a schematic cross-sectional view in an A-A direction in FIG.2;
FIG.7 is a schematic view of the connection of a first acquisition cable and a second acquisition cable with connecting plates in a traditional wiring mode;
FIG.8 is a schematic view of the connection between the first acquisition cable and the connecting plates in FIG.7;
FIG.9 is a schematic view of the connection between the second acquisition cable and the connecting plates in FIG.7;
FIG.10 is a top view of a battery module in a second embodiment of the present disclosure;
FIG.11 is a schematic view of the connection between a first acquisition cable and connecting plates in FIG. 10;
FIG.12 is a schematic view of the connection between a second acquisition cable and connecting plates in FIG. 10;
FIG.13 is a schematic view of the connection between a first acquisition cable and connecting plates in a third embodiment of the present disclosure;
FIG.14 is a schematic view of the connection between a second acquisition cable and connecting plates in a third embodiment of the present disclosure;
FIG.15 is a schematic view of the connection between a first acquisition cable and connecting plates in a fourth embodiment of the present disclosure;
FIG.16 is a schematic view of the connection between a second acquisition cable and connecting plates in a fourth embodiment of the present disclosure;
FIG.17 is a schematic view of the connection between a first acquisition cable and connecting plates in a traditional wiring mode;
FIG.18 is a schematic view of the connection between a second acquisition cable and connecting plates in a traditional wiring mode;
FIG.19 is a schematic view of the connection between a first acquisition cable and connecting plates in a fifth embodiment of the present disclosure; and
FIG.20 is a schematic view of the connection between a second acquisition cable and connecting plates in a fifth embodiment of the present disclosure.

### Reference numerals:

cell 100, positive electrode 110, negative electrode 120;
connector 200;
first acquisition cable 300, first conductor B₁, first conductor B₂, first conductor B₃, first conductor B₄, first conductor B₅, first conductor B₆;
second acquisition cable 400, second conductor C₁, second conductor C₂, second conductor C₃, second conductor C₄, second conductor C₅, second conductor C₆;
input terminal 500;
output terminal 600;
connecting plate A₁, connecting plate A₂, connecting plate A₃, connecting plate A₄, connecting plate A₅, connecting plate A₆, connecting plate A₇, connecting plate A₈, connecting plate A₉.

### DETAILED DESCRIPTION

Embodiments of the present disclosure will be described in detail below. Examples of the embodiments are illustrated in the accompanying drawings, where the same or like reference numerals throughout the figures indicate the same or like elements having the same or like functions. The embodiments described below with reference to the accompanying drawings are exemplary and are intended only to explain the present disclosure instead of being construed as limiting the present disclosure.

In the description of the present disclosure, it should be understood that, descriptions relating to orientation, for example, orientation or positional relationships indicated by "up", "down", "front", "back", "left", "right", etc. are based on the orientation or positional relationships shown in the accompanying drawings, and are to facilitate the description of the present disclosure and simplify the description only, rather than indicating or implying that the device or element referred to must have a specific orientation or be constructed and operated in a specific orientation, and therefore cannot be construed as limiting the present disclosure.

In the description of the present disclosure, the meaning of "several" is one or more, the meaning of "a plurality of" is two or more, "greater than", "less than", "more than", etc. are to be understood to exclude the given figure, and "above", "below", "within", etc. are understood to include the given figure. If "first" and "second", etc. are referred to, it is only for the purpose of distinguishing technical features, and shall not be understood as indicating or implying relative importance or implying the number of the indicated technical features or implying the sequence of the indicated technical features.

In the description of the present disclosure, unless otherwise explicitly defined, the words such as "set", "install", and "connect" should be understood in a broad sense, and those of ordinary skills in the art can determine the specific meanings of the above words in the present disclosure in a rational way in combination with the specific contents of the technical solutions.

In the description of the present disclosure, description with reference to the terms such as "an embodiment", "some embodiments", "illustrative embodiments", "an example", "specific examples", or "some examples" means that the specific features, structures, materials, or characteristics described in connection with that embodiment or example are included in at least one embodiment or example of the present disclosure. In this specification, schematic representations of the above terms do not necessarily refer to the same embodiment or example. Furthermore, the specific features, structures, materials or characteristics described may be combined in a suitable manner in any one or more embodiments or examples.

The present disclosure proposes a battery module, including a plurality of cells 100, a plurality of connecting plates, a first acquisition cable 300, and a second acquisition cable 400. The first acquisition cable 300 and the second acquisition cable 400 can perform jump voltage acquisition, thereby reducing the maximum voltage difference between corresponding conductors of the first acquisition cable 300 and the second acquisition cable 400 and reducing the faults such as electric leakage.

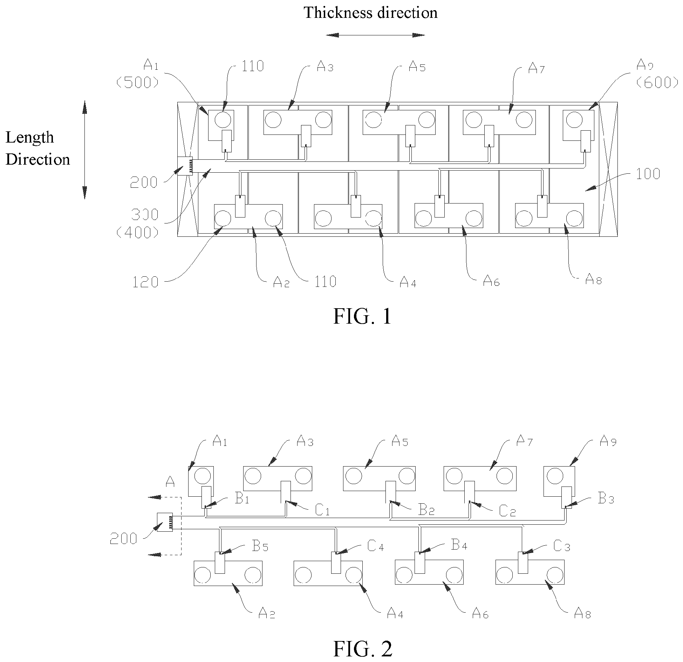

Referring to FIG.1, the battery module includes a plurality of cells 100. The cells 100 each may be a rectangular cell as shown in the figure. The plurality of cells 100 are arranged in sequence in a thickness direction. In some cases, the plurality of cells 100 are connected in series through a plurality of connecting plates. For example, the cells 100 each includes a positive electrode 110 and a negative electrode 120. The positive electrode 110 and the negative electrode 120 are arranged at both sides of the top of the cell 100 in a length direction of the cell 100. The plurality of cells 100 are connected in series through the connecting plates. Specifically, the positive electrodes 110 and the negative electrodes 120 of adjacent cells 100 are arranged oppositely, that is, for two adjacent cells 100, the positive electrode 110 of one cell 100 and the negative electrode 120 of the other cell 100 are located at the same side. In this way, the positive electrode 110 of a cell 100 and the negative electrode 120 of an adjacent cell 100 can be connected through one connecting plate, so that the adjacent cells 100 can be connected in series. By connecting each cell 100 in this way, all the cells 100 can be connected in series.

It should be noted that in other cases, some cells 100 of the plurality of cells 100 are connected in parallel first to form a parallel cell group, and then the parallel cell group is connected in series with other cells 100. In this case, the acquisition cable only needs to acquire the total voltage of the parallel cell group. The plurality of cells 100 can form one or more parallel cell groups.

Taking all cells 100 sequentially connected in series as an example, the sequentially connected battery module is as shown in FIG.1, a plurality of connecting plates are divided into two groups, the two groups of connecting plates are arranged in parallel in a length direction of the cells 100, all the connecting plates of each group are distributed in a thickness direction of the cells 100, and the two groups of connecting plates are arranged in a staggered manner in the thickness direction of the cells 100. For the convenience of description, according to the arrangement order of the connecting plates, the connecting plates are referred to as a connecting plate A₁, a connecting plate A₂, a connecting plate A₃, a connecting plate A₄, a connecting plate A₅, a connecting plate A₆, a connecting plate A₇, a connecting plate A₈, and a connecting plate A₉ in sequence respectively.

The first acquisition cable 300 includes a plurality of first conductors, and the plurality of first conductors are arranged in parallel in the thickness direction of the cells 100. The second acquisition cable 400 includes a plurality of second conductors, the plurality of second conductors are arranged in the thickness direction of the cells 100, and the number of the first conductors is equal to that of the second conductors. The first acquisition cable 300 and the second acquisition cable 400 are both connected to a connector 200. The connector 200 is provided with pins. The number of the pins is greater than or equal to the sum of the number of the first conductors and the number of the second conductors, that is, each conductor is electrically connected to a corresponding pin.

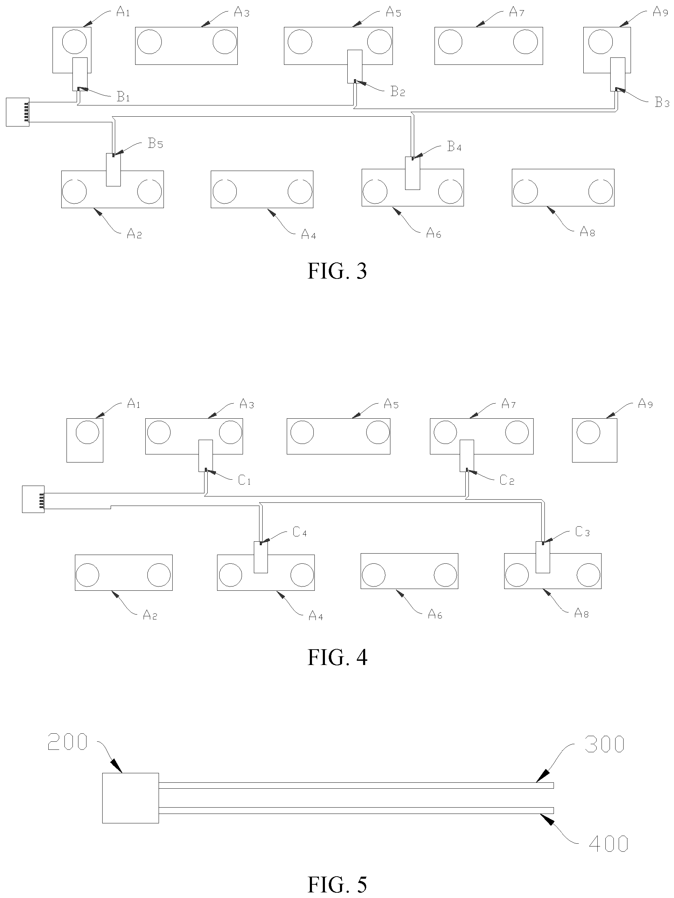

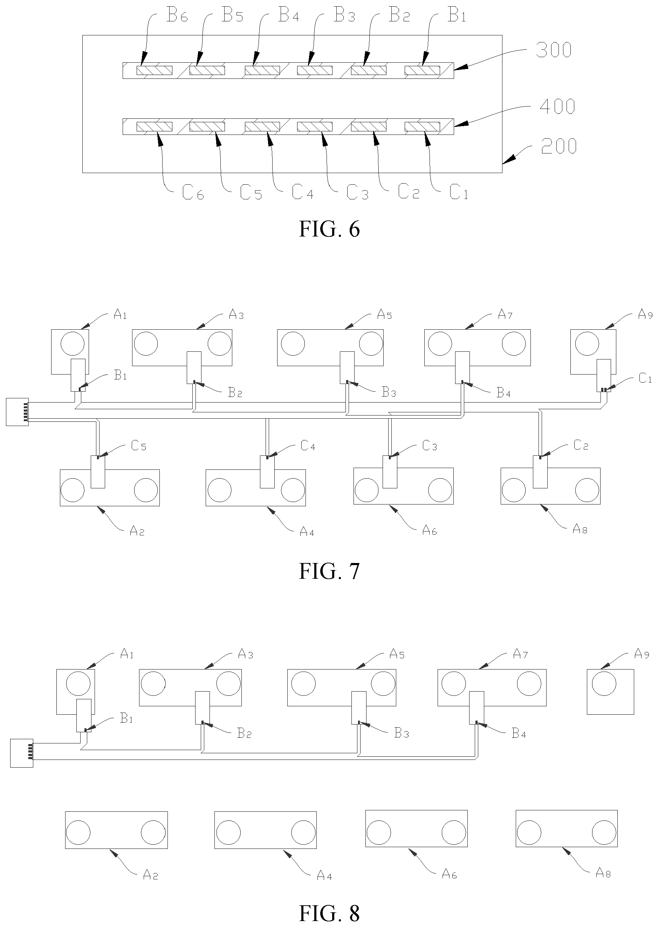

Referring to FIGS. 2 to 6, FIG.2 is a top view of the first acquisition cable 300 and the second acquisition cable 400 connected to the connector 200. FIG.3 is a schematic view of the connection between the first acquisition cable 300 and each connecting plate. FIG.4 is a schematic view of the connection between the second acquisition cable 400 and each connecting plate. FIG.5 is a side view of the first acquisition cable 300 and the second acquisition cable 400 connected to the connector 200. FIG.6 is a cross-sectional view in an A-A direction in FIG.2. The first acquisition cable 300 is stacked with the second acquisition cable 400. Taking what is shown in the figure as an example, the first acquisition cable 300 is located above the second acquisition cable 400, and the first conductors of the first acquisition cable 300 are arranged corresponding to the second conductors of the second acquisition cable 400. For the convenience of description, the first conductors are referred to as a first conductor B₁, a first conductor B₂, a first conductor B₃, a first conductor B₄, a first conductor B₅, and a first conductor B₆ in sequence respectively, and the second conductors are referred to as a second conductor C₁, a second conductor C₂, a second conductor C₃, a second conductor C₄, a second conductor C₅, and a second conductor C₆ in sequence respectively.

In order to avoid the risk of short circuit caused by cross-wiring connection (the so-called cross-wiring connection means that a conductor is connected to a connecting plate by crossing other conductors, for example, in FIG.2, the first conductor B₁ is bent toward the connecting plate A₂ and jumps over other first conductors, and then is connected to the connecting plate A₂), the conductors of the first acquisition cable 300 and the second acquisition cable 400 need to be connected to the connecting plates in the following mode. In the direction from the head end to the tail end of the first group of connecting plates, and then from the tail end to the head end of the second group of connecting plates, at least some of the first conductors are connected to some of the connecting plates in an arrangement order, and at least some of the second conductors are connected to other connecting plates in an arrangement order, thereby ensuring that each connecting plate is connected with at least one conductor and there is no cross-wiring problem for each conductor. Taking what is shown in FIG.7 to FIG.9 as an example, that is, in a direction from the connecting plate A₁, the connecting plate A₃, the connecting plate A₅, the connecting plate A₇, the connecting plate A₉, the connecting plate A₈, the connecting plate A₆, the connecting plate A₄ to the connecting plate A₂, the first conductor B₁, the first conductor B₂, the first conductor B₃, and the first conductor B₄ of different lengths are connected to the connecting plates in sequence. As shown in FIG.7, the second conductor C₁, the second conductor C₃, the second conductor C₄, and the second conductor C₅ of different lengths are also connected to the connecting plates in sequence (the first conductor B₅, the first conductor B₆ and the second conductor C₆ are not connected to the connecting plates and are in the vacant position), thus avoiding the problem of cross-wiring connection.

However, if all the first conductors are connected before the second conductors in sequence, a large voltage difference will occur between some of the first conductors and the respective second conductors. The reason is that all the cells 100 are connected in series, resulting in different voltages for different connecting plates. Consequently, the conductors connected to the connecting plates also have different voltages. When the voltage difference between a first conductor and a corresponding second conductor is too large, and there are foreign objects between the two, the problem of electric leakage is easy to occur. For example, referring to FIGS. 7 to 9, the voltage of the connecting plate A₁ is 0, the voltage of the connecting plate A₂ is the voltage across a single cell, recorded as V, and the voltage of the connecting plate A₃ is the voltage across two cells, recorded as 2V, and so on, and the voltage of the connecting plate A₉ is the voltage across eight cells, recorded as 8V. On the basis of ensuring that no cross-wiring problem occurs, the first acquisition cable 300 needs to be wired such that the first conductor B₁ is connected to the connecting plate A₁, the first conductor B₂ is connected to the connecting plate A₃, the first conductor B₃ is connected to the connecting plate A₅, and the first conductor B₄ is connected to the connecting plate A₇ (the first conductor B₅ and the first conductor B₆ are not connected to the connecting plates and are in the vacant position).

The second acquisition cable 400 needs to be wired such that the second conductor C₁ is connected to the connecting plate A₉, the second conductor C₂ is connected to the connecting plate A₈, the second conductor C₃ is connected to the connecting plate A₆, the second conductor C₄ is connected to the connecting plate A₄, and the second conductor C₅ is connected to the connecting plate A₂ (the second conductor C₆ is not connected to the connecting plate and is in a vacant position). Then the voltage differences between all first conductors and respective second conductors are shown in Table 1 below:

**Table 1**

| | First conductor B₁ | First conductor B₂ | First conductor B₃ | First conductor B₄ | First conductor B₅ | First conductor B₆ |
|---|---|---|---|---|---|---|
| First conductor voltage | 0 | 2V | 4V | 6V | Vacant | Vacant |
| | Second conductor C₁ | Second conductor C₂ | Second conductor C₃ | Second conductor C₄ | Second conductor C₅ | Second conductor C₆ |
| Second conductor voltage | 8V | 7V | 5V | 3V | 1V | Vacant |
| Voltage | 8V | 5V | 1V | 3V | / | / |
| difference | | | | | | |

As can be seen from the above table, the voltage difference between the first conductor B₁ and the second conductor C₁ is as high as 8V. As the number of cells 100 is increased, the maximum voltage difference may be further increased. Excessive voltage difference may easily cause the problem of electric leakage.

Based on the above, the first acquisition cable 300 and the second acquisition cable 400 of the present disclosure are wired in a jump mode, that is, at least one second conductor is arranged between at least one group of adjacent first conductors. In other words, after a certain first conductor is connected to a connecting plate, one or more second conductors are connected to the next connecting plate first, and then other first conductors are wired. In this way, the maximum voltage difference between the first conductor and the second conductor may be reduced. It should be noted that the above-mentioned "at least one group of adjacent first conductors" means that a plurality of pairs of first conductors may each have at least one second conductor arranged therebetween. Taking what is shown in FIG.2 to FIG.4 as an example, in some embodiments, in the direction from the head end to the tail end of the first group of connecting plates, and then from the tail end to the head end of the second group of connecting plates, the first conductors and the second conductors are connected to the respective connecting plates in an alternating and sequential manner, which can keep the voltage difference constant to 2V. Specifically, the wiring mode of the first acquisition cable 300 is adjusted as follows: the first conductor B₁ is connected to the connecting plate A₁, the first conductor B₂ is connected to the connecting plate A₅, the first conductor B₃ is connected to the connecting plate A₉, the first conductor B₄ is connected to the connecting plate A₆, and the first conductorB₅ is connected to the connecting plate A₂.

The wiring mode of the second acquisition cable 400 is adjusted as follows: the second conductor C₁ is connected to the connecting plate A₃, the second conductor C₂ is connected to the connecting plate A₇, the second conductor C₃ is connected to the connecting plate A₈, and the second conductor C₄ is connected to the connecting plate A₄. Then the voltage differences between all first conductors and the respective second conductors are shown in Table 2 below:

**Table 2**

| | First conductor B₁ | First conductor B₂ | First conductor B₃ | First conductor B₄ | First conductor B₅ | First conductor B₆ |
|---|---|---|---|---|---|---|
| First conductor voltage | 0 | 4V | 8V | 5V | IV | Vacant |

| | Second conductor C₁ | Second conductor C₂ | Second conductor C₃ | Second conductor C₄ | Second conductor C₅ | Second conductor C₆ |
|---|---|---|---|---|---|---|
| Second conductor voltage | 2V | 6V | 7V | 3V | Vacant | Vacant |
| Voltage difference | 2V | 2V | 1V | 2V | / | / |

As can be seen from the above table, the maximum voltage difference is constant at 2V, and the maximum voltage difference is significantly reduced.

In some embodiments, one of the plurality of connecting plates is used as an input terminal of the battery module, and a plurality of adjacent conductors of the same acquisition cable are connected to the input terminal. One of the plurality of connecting plates may be used as an output terminal of the battery module, and a plurality of adjacent conductors of the same acquisition cable are connected to the output terminal. Specifically, according to different usage states of the battery module, the battery module may be provided with an input terminal 500 and/or an output terminal 600. The input terminal 500 is connected with at least two adjacent conductors of the same acquisition cable, and the output terminal 600 is connected with at least two adjacent conductors of the same acquisition cable, that is, the input terminal 500 may be connected with at least two adjacent first conductors of the first acquisition cable 300, or connected with at least two adjacent second conductors of the second acquisition cable 400. It should be noted that the input terminal 500 or the output terminal 600 may be any one of the connecting plates.

Taking what is shown in FIG. 1 as an example, the battery module is provided with both an input terminal 500 and an output terminal 600, that is, the battery module can achieve input and output independently. Specifically, one of the plurality of connecting plates is used as the input terminal 500 of the battery module, another one of the connecting plates is used as the output terminal 600 of the battery module. The input terminal 500 is connected to one electrode of the first cell 100, and the output terminal 600 is connected to one electrode of the last cell 100. In this case, the input terminal 500 is connected with the first conductor B₁ and the first conductor B₂, the output terminal 600 is connected with the first conductor B₄ and the first conductor B₅, one of the two conductors connected to the input terminal 500 (or the output terminal 600) is used as a power line, and the other is used as an acquisition line. For example, the connecting plate A₁ is used as the input terminal 500 of the battery module, the first conductor B₁ is used as the input line of the battery module, the first conductor B₂ is used as a voltage acquisition line, the connecting plate A₉ is used as the output terminal 600 of the battery module, the second conductor C₁ is used as an output line of the battery module, and the second conductor C₂ is used as a voltage acquisition line.

In other modified embodiments, the battery module may also be provided with only the input terminal 500 or the output terminal 600. In this case, the battery module is used together with other battery modules in series. For example, for two battery modules, the first cell of the former battery module is connected with the input terminal 500, and the last cell of the latter battery module is connected with the output terminal 600. In this case, it is required to connect the last cell of the former battery module with the first cell of the latter battery module in series.

In other modified embodiments, the battery module may not be provided with the input terminal 500 and the output terminal 600. In this case, the battery module is used together with other battery modules in series. For example, for three battery modules, the first cell of the former battery module is connected with the input terminal 500, the last cell of the latter battery module is connected with the output terminal 600, and a middle battery module is not connected with either the input terminal 500 or the output terminal 600. When in use, it is required to connect the last cell of the former battery module with the first cell of the middle battery module in series, and connect the last cell of the middle battery module with the first cell of the latter battery module in series.

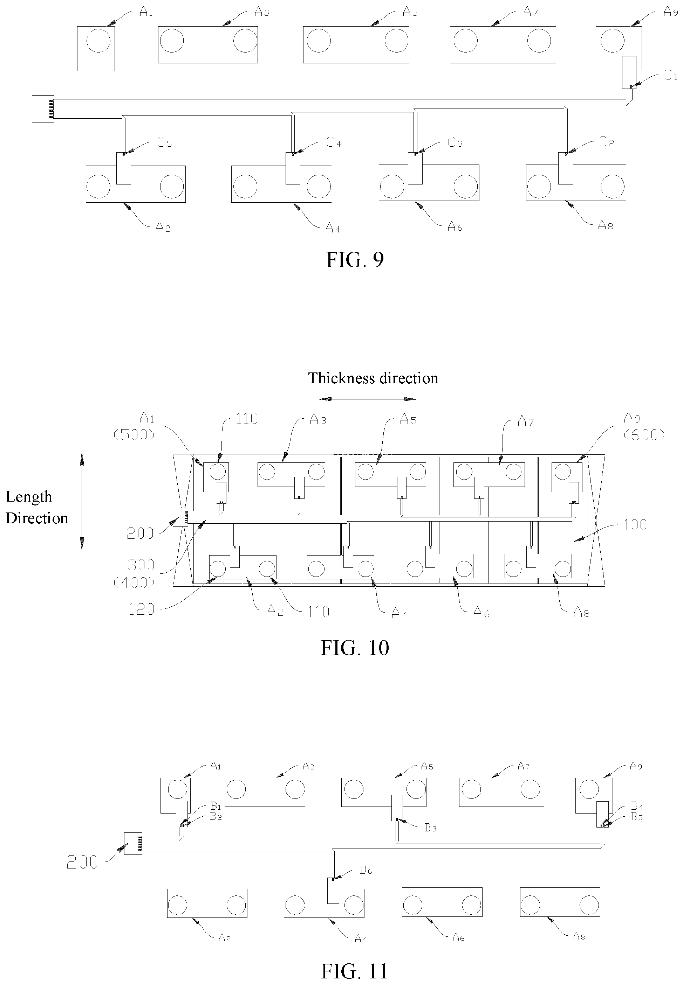

When the battery module is provided with both the input terminal 500 and the output terminal 600, with other conditions unchanged, referring to FIGS. 10 to 12, compared with the embodiment shown in FIG. 1, the wiring mode of the first acquisition cable 300 is adjusted as follows: the first conductor B₁ and the first conductor B₂ are both connected to the connecting plate A₁, the first conductor B₃ is connected to the connecting plate A₅, the first conductor B₄ and the first conductor B₅ are both connected to the connecting plate A₉, and the first conductor B₆ is connected to the connecting plate A₄.

The wiring mode of the second acquisition cable 400 is adjusted as follows: the second conductor C₁ is connected to the connecting plate A₃, the second conductor C₃ is connected to the connecting plate A₇, the second conductor C₄ is connected to the connecting plate A8, the second conductor C₅ is connected to the connecting plate A₆, and the second conductor C₆ is connected to the connecting plate A₂. Then the voltage differences between all first conductors and respective second conductors are shown in Table 3 below:

**Table 3**

| | First conductor B₁ | First conductor B₂ | First conductor B₃ | First conductor B₄ | First conductor B₅ | First conductor B₆ |
|---|---|---|---|---|---|---|
| First conductor voltage | 0 | 0 | 4V | 8V | 8V | 3V |

| | Second conductor C₁ | Second conductor C₂ | Second conductor C₃ | Second conductor C₄ | Second conductor C₅ | Second conductor C₆ |
|---|---|---|---|---|---|---|
| Second conductor voltage | 2V | Vacant | 6V | 7V | 5V | 1V |
| Voltage difference | 2V | / | 2V | 1V | 3V | 2V |

As can be seen from the above table, the maximum voltage difference occurs between the first conductor B₅ and the second conductor C₅, and the voltage difference is 3V. Compared with the above 8V, the maximum voltage difference is significantly reduced.

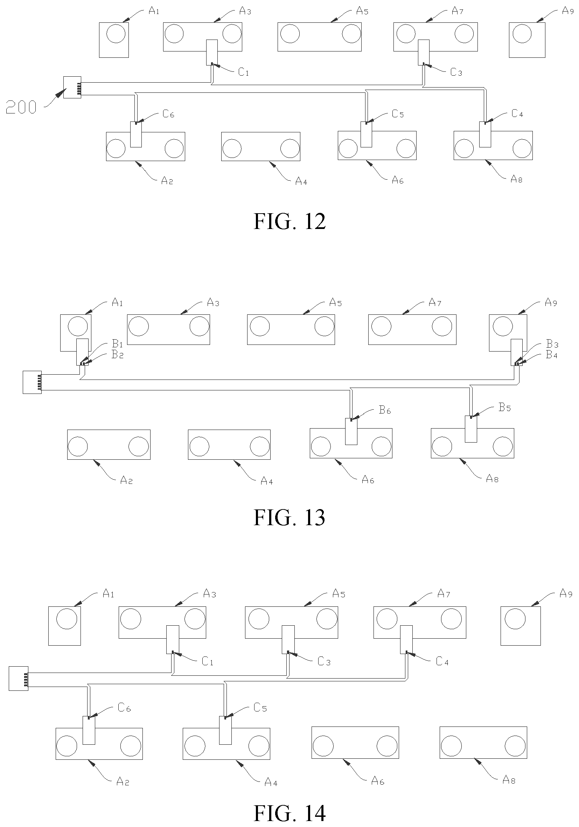

It should be noted that the present disclosure is not limited to the above embodiments. For example, in other embodiments, with other conditions unchanged, referring to FIGS. 13 and 14, the wiring mode of the first acquisition cable 300 is adjusted as follows: the first conductor B₁ and the first conductor B₂ are both connected to the connecting plate A₁, the first conductor B₃ and the first conductor B₄ are both connected to the connecting plate A₉, the first conductor B₅ is connected to the connecting plate A₈, and the first conductor B₆ is connected to the connecting plate A6.

The wiring mode of the second acquisition cable 400 is adjusted as follows: the second conductor C₁ is connected to the connecting plate A₃, the second conductor C₃ is connected to the connecting plate A₅, the second conductor C₄ is connected to the connecting plate A₇, the second conductor C₅ is connected to the connecting plate A₄, and the second conductor C₆ is connected to the connecting plate A₂. Then the voltage differences between all first conductors and respective second conductors are shown in Table 4 below:

**Table 4**

| | First conductor B₁ | First conductor B₂ | First conductor B₃ | First conductor B₄ | First conductor B₅ | First conductor B₆ |
|---|---|---|---|---|---|---|
| First conductor voltage | 0 | 0 | 8V | 8V | 7V | 5V |
| | Second conductor C₁ | Second conductor C₂ | Second conductor C₃ | Second conductor C₄ | Second conductor C₅ | Second conductor C₆ |
| Second conductor voltage | 2V | Vacant | 4V | 6V | 3V | 1V |
| Voltage difference | 2V | / | 4V | 2V | 4V | 4V |

As can be seen from the above table, the maximum voltage difference occurs between the first conductor B₃ and the second conductor C₃, between the first conductor B₅ and the second conductor C₅, and between the first conductor B₆ and the second conductor C₆, and the voltage difference is 4V. Compared with the above 8V, the maximum voltage difference is significantly reduced.

In addition, in this embodiment, only one group of adjacent first conductors have at least one second conductor arranged therebetween.

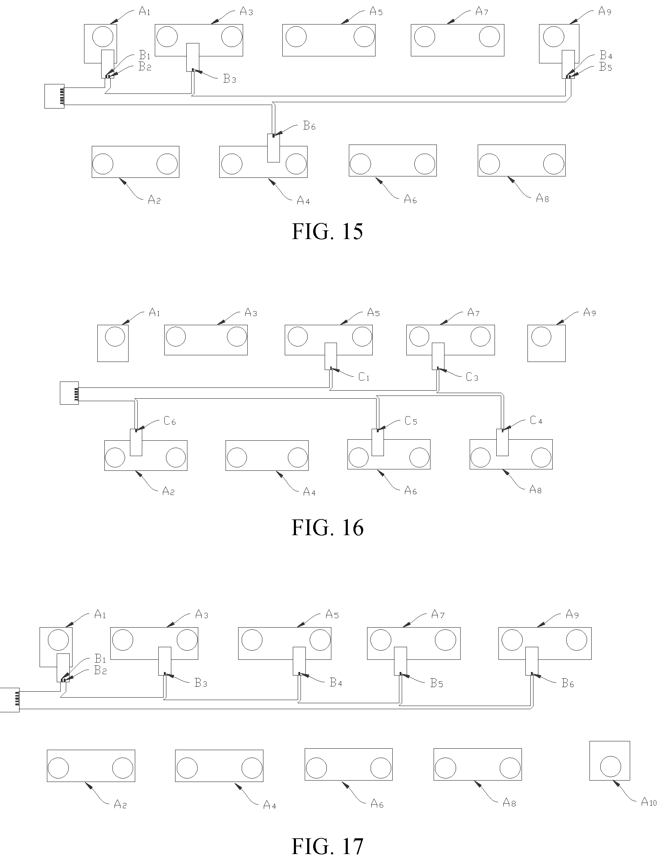

For another example, in other embodiments, with other conditions unchanged, referring to FIGS. 15 and 16, the wiring mode of the first acquisition cable 300 is adjusted as follows: the first conductor B₁ and the first conductor B₂ are both connected to the connecting plate A₁, the first conductor B₃ is connected to the connecting plate A₃, the first conductor B₄ and the first conductor B₅ are both connected to the connecting plate A₉, and the first conductor B₆ is connected to the connecting plate A₄.

The wiring mode of the second acquisition cable 400 is adjusted as follows: the second conductor C₁ is connected to the connecting plate A₅, the second conductor C₃ is connected to the connecting plate A₇, the second conductor C₄ is connected to the connecting plate A₈, the second conductor C₅ is connected to the connecting plate A₆, and the second conductor C₆ is connected to the connecting plate A₂. Then the voltage differences between all first conductors and respective second conductors are shown in Table 5 below:

**Table 5**

| | First conductor B₁ | First conductor B₂ | First conductor B₃ | First conductor B₄ | First conductor B₅ | First conductor B₆ |
|---|---|---|---|---|---|---|
| First conductor voltage | 0 | 0 | 2V | 8V | 8V | 3V |
| | Second conductor C₁ | Second conductor C₂ | Second conductor C₃ | Second conductor C₄ | Second conductor C₅ | Second conductor C₆ |
| Second conductor voltage | 4V | Vacant | 6V | 7V | 5V | 1V |
| Voltage difference | 4V | / | 4V | 1V | 3V | 2V |

As can be seen from the above table, the maximum voltage difference occurs between the first conductor B₁ and the second conductor C₁, and between the first conductor B₃ and the second conductor C₃, and the voltage difference is 4V. Compared with the above 8V, the maximum voltage difference is significantly reduced.

In addition, in this embodiment, each pair of adjacent first conductors have two second conductors arranged therebetween.

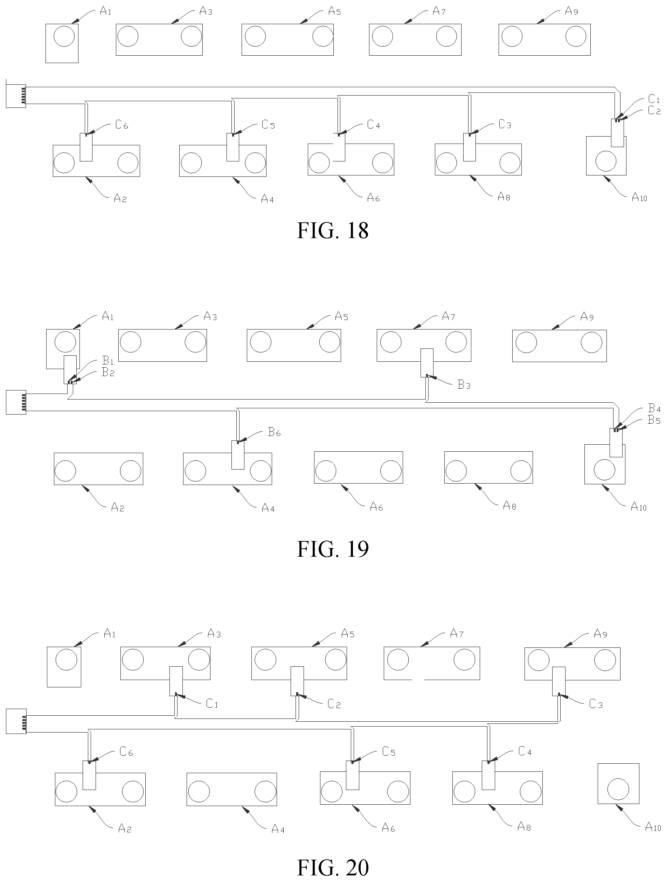

For another example, in other embodiments, the number of cells 100 may change. Referring to FIGS. 17 and 18, the number of cells 100 is increased from 8 to 9. When using the traditional wiring mode shown in the figure, the voltage differences between all first conductors and respective second conductors are shown in Table 6 below:

**Table 6**

| | First conductor B₁ | First conductor B₂ | First conductor B₃ | First conductor B₄ | First conductor B₅ | First conductor B₆ |
|---|---|---|---|---|---|---|
| First conductor voltage | 0 | 0 | 2V | 4V | 6V | 8V |

| | Second conductor C₁ | Second conductor C₂ | Second conductor C₃ | Second conductor C₄ | Second conductor C₅ | Second conductor C₆ |
|---|---|---|---|---|---|---|
| Second conductor voltage | 9V | 9V | 7V | 5V | 3V | 1V |
| Voltage difference | 9V | 9V | 5V | 1V | 3V | 7V |

As can be seen from the above table, the voltage difference of 9V occurs between the first conductor B₁ and the second conductor C₁, and between the first conductor B₂ and the second conductor C₂, and the maximum voltage difference is further increased.

With other conditions unchanged, referring to FIGS. 19 and 20, the wiring mode of the first acquisition cable 300 is adjusted as follows: the first conductor B₁ and the first conductor B₂ are both connected to the connecting plate A₁, the first conductor B₃ is connected to the connecting plate A₇, the first conductor B₄ and the first conductor B₅ are both connected to the connecting plate A₁₀, and the first conductor B₆ is connected to the connecting plate A₄.

The wiring mode of the second acquisition cable 400 is adjusted as follows: the second conductor C₁ is connected to the connecting plate A₃, the second conductor C₂ is connected to the connecting plate A₅, the second conductor C₃ is connected to the connecting plate A₉, the second conductor C₄ is connected to the connecting plate A₈, the second conductor C₅ is connected to the connecting plate A₆, and the second conductor C₆ is connected to the connecting plate A₂. Then the voltage differences between all first conductors and respective second conductors are shown in Table 7 below:

**Table 7**

| | First conductor B₁ | First conductor B₂ | First conductor B₃ | First conductor B₄ | First conductor B₅ | First conductor B₆ |
|---|---|---|---|---|---|---|
| First conductor voltage | 0 | 0 | 6V | 9V | 9V | 3V |

| | Second conductor C₁ | Second conductor C₂ | Second conductor C₃ | Second conductor C₄ | Second conductor C₅ | Second conductor C₆ |
|---|---|---|---|---|---|---|
| Second conductor voltage | 2V | 4V | 8V | 7V | 5V | 1V |
| Voltage difference | 2V | 4V | 2V | 2V | 4V | 2V |

As can be seen from the above table, the maximum voltage difference occurs between the first conductor B₂ and the second conductor C₂, and between the first conductor B₅ and the second conductor C₅, and the voltage difference is 4V. Compared with the above 9V, the maximum voltage difference is significantly reduced.

It can be understood that for a battery module, the number of cells 100 may be further increased or decreased, which will not be listed one by one here.

In the battery module of the embodiment of the present disclosure, at least one second conductor is arranged between each of a plurality of groups of adjacent first conductors. For example, in the embodiment shown in FIG.11, one second conductor is arranged between the first conductor B₂ and the first conductor B₃, and one second conductor is also arranged between the first conductor B₃ and the first conductor B₄. On the other hand, a plurality of second conductors are arranged between each group of first conductors. For example, in the embodiment shown in FIG.15, two second conductors are arranged between the first conductor B₃ and the first conductor B₄. The above two solutions may be combined, and the number of the second conductors between each group of adjacent first conductors may be identical. For example, in the embodiment shown in FIG.15, two second conductors are arranged between the first conductor B₃ and the first conductor B₄, and two second conductors are also arranged between the conductor B₅ and the first conductor B₆. The number of the second conductors between each group of adjacent first conductors may be different. For example, in the embodiment shown in FIG.11, one second conductor is arranged between the first conductor B₂ and the first conductor B₃, and two second conductors are arranged between the first conductor B₅ and the first conductor B₆. In this way, flexible wiring of the first conductors and the second conductors can be achieved, thereby reducing the maximum voltage difference.

In other embodiments of the present disclosure, the first acquisition cable 300 is provided with a vacant position corresponding to at least one second conductor. The so-called vacant position means that the first conductor corresponding to the second conductor is in a disconnected state, for example, the first conductor is not connected to the connecting plate. The vacant position is caused by the inconsistency between the number of conductors and the number of connection points. Taking what is shown in FIG.1 as an example, the first acquisition cable 300 and the second acquisition cable 400 have a total of 12 conductors, and the battery module has 9 connecting plates, where the connecting plate A₂, the connecting plate A₃, the connecting plate A₄, the connecting plate A₅, the connecting plate A₆, the connecting plate A₇ and the connecting plate A₈ all need to be connected to one conductor, so the entire battery module has 9 connection points, and the number of the conductors is 3 more than the number of the connection points. The first conductor B₅, the first conductor B₆, and the second conductor C₆ are not connected to the connecting plate and are in the vacant position. In addition, taking what is shown in FIG.10 as an example, the connecting plate A₁ and the connecting plate A₉ not only need to acquire voltages, but also need to undertake input and output functions, so each needs to connect two conductors. Therefore, the entire battery module has 11 connection points, and the number of the conductors is 1 more than the number of the connection points, so one vacant position will be generated. It should be noted that according to the difference between the number of the connection points and the number of the conductors, the number of vacant positions may also be set to 2, 3 or others. When the number of the connection points is the same as the number of the conductors, there is no vacant position. In addition, the location of the vacant position is not limited and may be set at any location of the first acquisition cable 300 or any location of the second acquisition cable 400.

There is no voltage difference between the first conductor in a disconnected state and a corresponding second conductor, and there is no corresponding problem of electric leakage. Therefore, when it is difficult to reduce the voltage difference between a certain group of first conductor and second conductor by jump acquisition, or reducing the voltage difference between the first conductor and the second conductor of this group will cause the voltage difference of another pair of first conductor and second conductor to increase, at least one of the first conductor and the second conductor of this group may be set as a vacant position, thus eliminating the voltage difference.

Similarly, the second acquisition cable 400 is provided with a vacant position corresponding to at least one first conductor, and the mode and function are the same as those of the first acquisition cable 300.

When the battery module is provided with an input terminal 500, and the input terminal 500 is connected to the first cell 100, the number of first conductors is recorded as M, and the input terminal 500 is connected with the first one and the second one of the first conductors. Taking what is shown in FIG. 10 as an example, the input terminal 500 is connected to the first conductor B₁ and the first conductor B₂. From the second one of the first conductors to the M^{th} one of the first conductors, at least two groups of adjacent first conductors may each have at least one second conductor arranged therebetween. For example, taking what is shown in FIG.10 as an example, from the first conductor B₂, the first conductor B₃, the first conductor B₄, the first conductor B₅ to the first conductor B₆, at least one second conductor is arranged between the first conductor B₂ and the first conductor B₃, at least one second conductor is arranged between the first conductor B₃ and the first conductor B₄, and at least one second conductor is arranged between the first conductor B₅ and the first conductor B₄. In conjunction with FIGS. 10 to 12, FIGS. 15 to 18, and FIGS. 19 to 20, this arrangement mode is suitable for a battery module with an input terminal 500, and can significantly reduce the maximum voltage difference between a first conductor and a second conductor.

Based on the above embodiment, the second acquisition cable 400 is provided with a vacant position corresponding to the second one of the first conductors (for example, the first conductor B₂ in the figure). In conjunction with FIGS. 10 to 12, FIGS. 15 to 18, and FIGS. 19 to 20, when both the first conductor B₁ and the first conductor B₂ are connected to the input terminal 500, the voltage thereof is the lowest among the voltages of all the conductors, so a large voltage difference is easily generated. The first conductors and the second conductors are wired in a direction from the head end to the tail end of the first group of connecting plates, and then from the tail end to the head end of the second group of connecting plates. Therefore, the voltage of the second conductor corresponding to the first conductor B₂ is inevitably higher than that of the second conductor corresponding to the first conductor B₃, that is, a large voltage difference is more likely to occur at the first conductor B₂. Based on this, by setting a vacant position in the second acquisition cable 400 corresponding to the first conductor B₂, the voltage difference at the first conductor B₂ can be eliminated.

In some embodiments, in the direction from the head end to the tail end of the first group of connecting plates, and then from the tail end to the head end of the second group of connecting plates, the last one of the first conductors and the last one of the second conductors are connected with two adjacent connecting plates in sequence. According to the aforementioned wiring mode, the last one of the second conductors is fixed in connection position, that is, connected to the connecting plate connected in series between the first cell and the second cell. Therefore, the voltage of the last one of the second conductors is fixed at 1V. Based on this, the closer the last one of the first conductors corresponding thereto is, the lower the voltage difference is. Referring to FIGS. 10 to 12, the first conductor B₆ is connected to the connecting plate A₄, the second conductor C₆ is connected to the connecting plate A₂, the voltage of the second conductor C₆ is 1V, and the voltage of the first conductor B₆ is 3V, so the voltage difference can be kept at 2V. If the first conductor B₆ is connected to the connecting plate A₆ or the connecting plate A₈, the voltage difference will be increased to 4V and 6V respectively. Therefore, connecting the last one of the first conductor and the last one of the second conductors to two adjacent connecting plates in sequence can help reduce the voltage difference.

The present disclosure also proposes a voltage acquisition method, including:
preparing a plurality of cells 100, a plurality of connecting plates, a first acquisition cable 300, and a second acquisition cable 400, where the plurality of cells 100 are arranged in sequence, the plurality of connecting plates are divided into two groups, all the connecting plates of each group are distributed in an arrangement direction of the cells 100, the plurality of cells 100 are connected in series through two groups of connecting plates, the first acquisition cable 300 includes a plurality of first conductors arranged in parallel, and the second acquisition cable 400 includes a plurality of second conductors arranged in parallel; and
stacking the first acquisition cable 300 with the second acquisition cable 400, in a direction from a head end to a tail end of the first group of connecting plates, and then from a tail end to a head end of the second group of connecting plates, connecting at least some of the first conductors to some of the connecting plates in an arrangement order, connecting at least some of the second conductors to other connecting plates in an arrangement order, and arranging at least one second conductor between at least one group of adjacent first conductors, so that the voltage differences between all first conductors and respective second conductors are all less than a set value.

The above acquisition method can be understood in conjunction with FIGS. 1 to 20 and corresponding embodiments, which will not be described in detail here.

It should be noted that the above set value may be adjusted as needed.

Based on the above acquisition solution, in some embodiments of the present disclosure, the total number of first conductors and second conductors is set to be greater than the number of connection points, where the connection points include acquisition points where conductors used as acquisition points are connected to connecting plates, and input points or output points where the conductors used as power lines are connected to the connecting plates, in this way, at least one conductor does not need to be connected to the connecting plate.

The acquisition solution further includes a judgment step: after a group of first conductor and second conductor are connected to corresponding connecting plates respectively, judging a voltage difference between the first conductor and the second conductor of the group; and if the voltage difference is greater than a set value, disconnecting at least one of the first conductor and the second conductor to form a vacant position so as to avoid generating a voltage difference. It should be noted that the judgment step may be an actual detection step, for example, after the conductors are respectively connected to the connecting plates, detecting a voltage difference between corresponding pins of the connector 200 by a detection device. The judgment step may also be a simulation detection step, for example, after identifying that the conductors are connected to the connecting plates respectively, inferring the voltage difference between the conductors.

In the above embodiment, by setting the vacant position, a corresponding relationship between the first conductor and the second conductor can be flexibly adjusted, and then the maximum voltage difference between the conductors can be controlled.

The embodiments of the present disclosure are described in detail above in conjunction with the accompanying drawings. However, the present disclosure is not limited to the above embodiments. Within the scope of knowledge possessed by those of ordinary skills in the art, various changes can be made without departing from the purpose of the present disclosure. In addition, the embodiments of the present disclosure and the features in the embodiments may be combined with each other without conflict.

## Claims

1. A battery module, comprising:
a plurality of cells;
two groups of connecting plates, wherein the two groups of connecting plates are arranged in parallel, and all the connecting plates of each group distributed in an arrangement direction of the cells;
a first acquisition cable, which comprises a plurality of first conductors arranged in parallel, and
a second acquisition cable, which is stacked with the first acquisition cable and comprises a plurality of second conductors, wherein in a direction from a head end to a tail end of a first group of connecting plates, and then from a tail end to a head end of a second group of connecting plates, at least some of the first conductors are connected to some of the connecting plates in an arrangement order of the first conductors, at least some of the second conductors are connected to other connecting plates in an arrangement order of the second conductors, and at least one of the second conductors is arranged between at least one group of adjacent first conductors.

2. The battery module according to claim 1, wherein in the direction from the head end to the tail end of the first group of connecting plates, and then from the tail end to the head end of the second group of connecting plates, the first conductors and the second conductors are connected to the respective connecting plates in an alternating and sequential manner.

3. The battery module according to claim 1, wherein at least one of the second conductors is arranged between each of a plurality of groups of adjacent first conductors, and/or a plurality of the second conductors are arranged between at least one group of adjacent first conductors.

4. The battery module according to claim 1, wherein the first acquisition cable is provided with a vacant position corresponding to at least one of the second conductors, and/or the second acquisition cable is provided with a vacant position corresponding to at least one of the first conductors.

5. The battery module according to claim 1, wherein one of the plurality of connecting plates is used as an input terminal of the battery module, and a plurality of adjacent conductors of a same acquisition cable are connected to the input terminal.

6. The battery module according to claim 5, wherein the input terminal is connected to a first one of the cells, the input terminal is connected with a first one of the first conductors and a second one of the first conductors, and at least one of the second conductors is arranged between each of a plurality of groups of adjacent first conductors after the first one of the first conductors.

7. The battery module according to claim 6, wherein the second acquisition cable is provided with a vacant position corresponding to the second one of the first conductors.

8. The battery module according to claim 6, wherein in the direction from the head end to the tail end of the first group of connecting plates, and then from the tail end to the head end of the second group of connecting plates, a last one of the first conductors and a last one of the second conductors are connected to the two adjacent connecting plates in sequence.

9. A voltage acquisition method, comprising:
preparing a plurality of cells, a plurality of connecting plates, a first acquisition cable, and a second acquisition cable, wherein the plurality of cells are arranged in sequence, the plurality of connecting plates are divided into two groups, all the connecting plates of each group are distributed in an arrangement direction of the cells, the first acquisition cable comprises a plurality of first conductors arranged in parallel, and the second acquisition cable comprises a plurality of second conductors arranged in parallel; and
stacking the first acquisition cable with the second acquisition cable, in a direction from a head end to a tail end of a first group of connecting plates, and then from a tail end to a head end of a second group of connecting plates, connecting at least some of the first conductors to some of the connecting plates in an arrangement order of the first conductors, connecting at least some of the second conductors to other connecting plates in an arrangement order of the second conductors, and arranging at least one of the second conductors between at least one group of adjacent first conductors, so that a voltage difference between each of the first conductors and a corresponding second conductor is lower than a set value.

10. The voltage acquisition method according to claim 9, wherein a sum of the number of the first conductors and the number of the second conductors is greater than the number of connection points, and the method further comprises:
judging whether the voltage difference is greater than the set value after a group of the first conductors and the second conductors are all connected to the respective connecting plates, and
in response to the voltage difference being greater than the set value, forming a vacant position corresponding to at least one of the first conductors and the second conductors.
